# EUROPEAN PATENT APPLICATION

(11) **EP 2 608 279 A2**
(43) Date of publication of application: **26.06.2013**
(21) Application number: 12005142.0
(22) Date of filing: 12.07.2012
(51) Int. Cl.: H01L 31/068, H01L 31/0224

(54) **Solar cell**

(30) Priority: 23.12.2011 KR 20110141144
(71) Applicant: LG Electronics Inc., Yeongdeungpo-gu Seoul 150-721 (KR)
(72) Inventor: Lee, Kyoungsoo, 137-724 Seoul (KR); Choi, Hyungwook, 137-724 Seoul (KR)
(74) Representative: Katérle, Axel

(57) **Abstract**

A solar cell according to an embodiment includes a semiconductor substrate (10); an emitter layer (20) formed on at least one of a front surface and a back surface of the semiconductor substrate; a back surface field layer (30) formed on the back surface of the semiconductor substrate; a first electrode (24) formed on the emitter layer; and a second electrode (34) formed on the back surface field layer. The back surface field layer includes a first portion (30a)formed at a portion where the second electrode is not formed and having a first resistance, and a second portion (30b) in contact with the second electrode and having a second resistance lower than the first resistance. The second electrode (34) includes a plurality of finger electrodes (34a) that are parallel to each other and are spaced apart with distances of about 0.1 to about 1mm, and have widths of about 50µm to about 70µm.

## Description

### BACKGROUND OF THE INVENTION

### 1. Field of the invention

Embodiments of the invention relate to a solar cell, and more particularly, to a solar cell having an emitter layer and a back surface field layer.

### 2. Description of the Related Art

Recently, as existing energy resources such as oil or coal are expected to be exhausted, an interest in alternative energy resources for replacing oil or coal is increasing. In particular, a solar cell that directly converts or transforms solar energy into electricity is gaining attention.

A solar cell is manufactured by forming a plurality of layers and electrodes according to a predetermined design. In this instance, efficiency of the solar cell may be varied depending on the design of the plurality of layers and electrodes. For example, when an area of an electrode is excessively large, shading loss and an amount of materials used for manufacturing a solar cell may increase. When the area of the electrode is excessively small, resistance of the solar cell may increase. Therefore, the plurality of layers and electrodes need to be designed in order to maximize the efficiency of a solar cell.

### SUMMARY OF THE INVENTION

Embodiments of the invention are directed to a solar cell being able to maximize the efficiency and minimize an amount of materials used for manufacturing a solar cell.

A solar cell according to an embodiment of the invention includes a semiconductor substrate of a first conductive type; an emitter layer of a second conductive type, and formed on at least one of a front surface and a back surface of the semiconductor substrate; a back surface field layer formed on the back surface of the semiconductor substrate; a first electrode formed on the emitter layer and electrically connected to the emitter layer; and a second electrode formed on the back surface field layer and electrically connected to the back surface field layer. The back surface field layer includes a first portion formed at a portion where the second electrode is not formed and having a first resistance, and a second portion in contact with the second electrode and having a second resistance lower than the first resistance. The second electrode includes a plurality of finger electrodes. The plurality of finger electrodes are parallel to each other and are spaced apart from each other with distances of about 0.1 to about 1mm, and the plurality of finger electrodes have widths of about 50µm to about 70µm.

### BRIEF DESCRIPTION OF THE DRAWINGS

FIG. 1 is a rear perspective view of a solar cell according to an embodiment of the invention.

FIG. 2 is a cross-sectional view of a part of the solar cell shown in FIG. 1.

FIG. 3 is a plan view illustrating a second electrode of a solar cell according to an embodiment of the invention.

FIG. 4 is a graph of a series resistance of a solar cell of an Experimental Embodiment of the invention.

FIG. 5 is a graph of a saturation current of the solar cell of the Experimental Embodiment of the invention.

FIG. 6 is a graph of a product of the series resistance and the saturation current of the solar cell of the Experimental Embodiment of the invention.

FIG. 7 is a graph of a series resistance of a solar cell of a Comparative Embodiment 1 of the invention.

FIG. 8 is a graph of a saturation current of the solar cell of the Comparative Embodiment 1 of the invention.

FIG. 9 is a graph of a product of the series resistance and the saturation current of the solar cell of the Comparative Embodiment 1 of the invention.

FIG. 10 is a graph of a product of the series resistance and the saturation current of the solar cell of a Comparative Embodiment 2 of the invention.

FIG. 11 is a graph of a product of the series resistance and the saturation current of the solar cell of a Comparative Embodiment 3 of the invention.

FIG. 12 is a cross-sectional view of a solar cell according to another embodiment of the invention.

### DETAILED DESCRIPTION OF THE EMBODIMENTS

Hereinafter, embodiments of the invention will be described with reference to the accompanying drawings. However, the invention is not limited the embodiments, and the various modifications of the embodiments are possible.

In order to clearly and concisely illustrate the embodiments of the invention, elements not related to the invention are omitted in the figures. Also, elements similar to or the same as each other have the same reference numerals. In addition, the dimensions of layers and regions are exaggerated or schematically illustrated, or some layers are omitted for clarity of illustration. In addition, the dimension of each part as drawn may not reflect an actual size.

In the following description, when a layer or substrate "includes" another layer or portion, it can be understood that the layer or substrate further includes still another layer or portion. Also, when a layer or film is referred to as being "on" another layer or substrate, it can be directly on the other layer or substrate, or intervening layers can also be present. Further, when a layer or film is referred to as being "directly on" another layer or substrate, it can be directly on the other layer or substrate, and thus, there is no intervening layer.

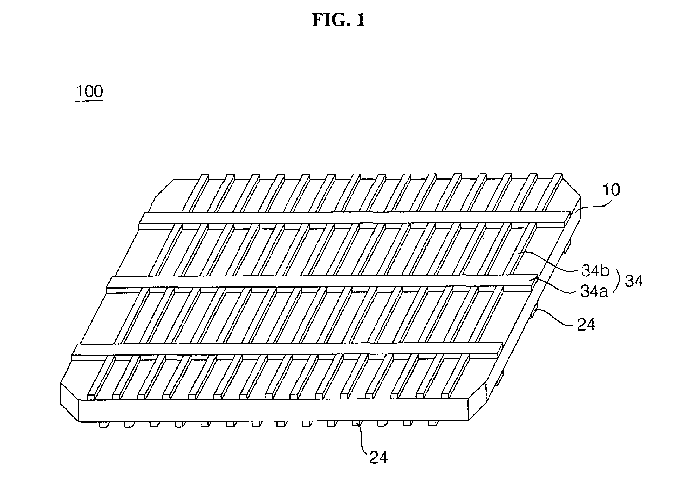

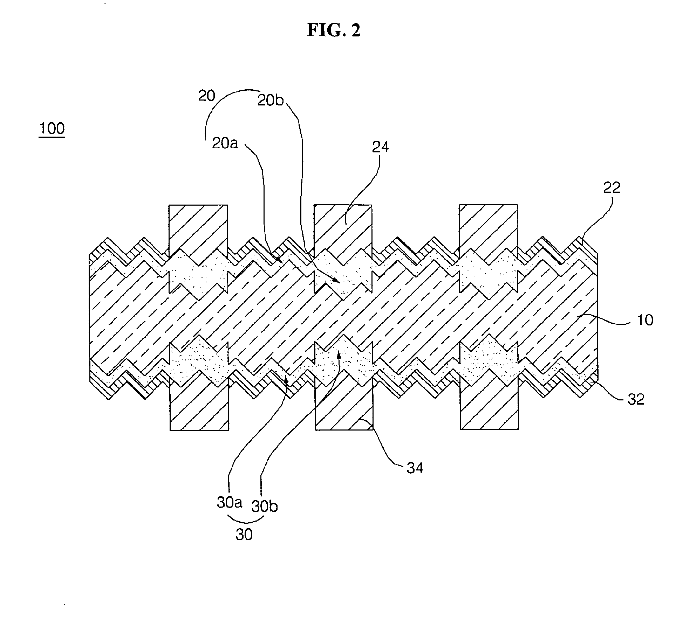

FIG. 1 is a rear perspective view of a solar cell according to an embodiment of the invention, and FIG. 2 is a cross-sectional view of a part of the solar cell shown in FIG. 1.

Referring to FIGS. 1 and 2, a solar cell 100 according to an embodiment of the embodiment includes a semiconductor substrate 10, an emitter layer 20 formed at or adjacent to at least one of a first surface (hereinafter, referred to as "a front surface") and a second surface (hereinafter, referred to as "a back surface") of the semiconductor substrate 10, and a back surface field layer 30 formed at or adjacent to the back surface of the semiconductor substrate 10. Also, the solar cell 100 may include an anti-reflection film 22 and a first electrode 24 (or a plurality of first electrodes) formed on the front surface of the semiconductor substrate 10, and may include a passivation film 32 and a second electrode 34 (or a plurality of second electrodes) formed on the back surface of the semiconductor substrate 10.

The semiconductor substrate 10 may include various semiconductor materials. For example, the semiconductor substrate 10 may include silicon having first conductivity type dopants. For the silicon, single crystal silicon or polycrystalline silicon may be used. For example, the first conductivity type may be an n-type. That is, the semiconductor substrate 10 may include single crystal silicon or polycrystalline silicon having doped therein, a group V element, such as phosphorus (P), arsenic (As), bismuth (Bi), antimony (Sb), or the like.

When the semiconductor substrate 10 has the n-type dopant as above, the emitter layer 20 having a p-type dopant is formed at the front surface of the semiconductor substrate 10, and thereby forming a p-n junction. When light (such as sun light) is incident on the semiconductor substrate 10, electrons generated by the photoelectric effect moves to the back surface of the semiconductor substrate 10 and are collected by the second electrode 34, and holes generated by the photoelectric effect moves to the front surface of the semiconductor substrate 10 and are collected by the first electrode 24. Then, the electric energy is generated thereby.

In this instance, the holes having mobility smaller than the electrodes moves to the front surface of the semiconductor substrate 10, and not the back surface of the semiconductor substrate 10. Therefore, the conversion efficiency of the solar cell 100 can be enhanced.

However, embodiments of the invention are not limited thereto, and thus, the semiconductor substrate 10 may have p-type dopants and the emitter layer 20 may have n-type dopants.

The front and back surfaces of the semiconductor substrate 10 may be a textured surface to have protruded and/or depressed portions of various shapes (such as a pyramid shape). When the surface roughness is increased by the protruded and/or depressed portions, reflectance of the incident sun light at the front surface of the semiconductor substrate 10 can be reduced by the texturing. Then, an amount of the light reaching the p-n junction between the semiconductor substrate 10 and the emitter layer 20 can increase, thereby reducing an optical loss of the solar cell 100.

For the texturing method, a wet etching method or a dry etching method may be used. In the wet etching method, the semiconductor substrate 10 may be dipped into a texturing solution (or an etching solution). According to the wet etching method, the process time can be short. In the dry etching method, the surface of the semiconductor substrate 10 is etched by a diamond drill or a laser. In the dry etching, the protruded and/or depressed portions can be uniformly formed, but the semiconductor substrate 10 may be damaged and the process time may be long. As shown above, in this embodiment of the invention, the semiconductor substrate 10 may be textured by various methods.

The emitter layer 20 having the second conductive type dopant may be formed at the front surface of the semiconductor substrate 10. The emitter layer 20 may include a p-type dopant such as a group III element, for example, boron (B), aluminum (Al), gallium (Ga), or the like. However, embodiments of the invention are not limited thereto. Thus, when the semiconductor substrate 10 is the p-type, the emitter layer 20 may be the n-type.

In embodiments of the invention, the emitter layer 20 includes a first portion 20a formed adjacent to (or abutting) the anti-reflection film 22 where the first electrode 24 is not formed, and a second portion 20b being in contact with the first electrode 24. The second portion 20b has a second resistance lower than a first resistance of the first portion 20a.

Thus, a shallow emitter can be achieved at the first portion 20a where the sun light is incident, thereby enhancing the efficiency of the solar cell 100. In addition, contact resistance between the first electrode 24 and the second portion 20b can be reduced by the second portion 20b. That is, since the emitter layer 20 has the selective emitter structure in having the first portion 20a and the second portion 20b, the efficiency of the solar cell 100 can be maximized.

In this instance, the first portion 20a of the emitter layer 20 has a resistance of about 70∼110 ohm/square, and the second portion 20b of the emitter layer 20 has a resistance of about 20-40 ohm/square. When the first portion 20a has a resistance of about 70∼110 ohm/square, the passivation property thereof can be maximized. Also, when the second portion 20b has a resistance of about 20-40 ohm/square, the resistance thereof with the first electrode 24 can be reduced. However, embodiments of the invention are not limited thereto, and thus, the resistances may be varied

The emitter layer 20 may be formed by various methods. For example, the emitter layer 20 may be formed by an ion implantation method using a shadow mask, an etch-back method using a mask, a laser doping method, and so on.

The anti-reflection film 22 and the first electrode 24 may be formed on the emitter 20 at the front surface of the semiconductor substrate 10.

The anti-reflection film 22 may be substantially at the entire front surface of the semiconductor substrate 10, except for the portion where the first electrode 24 is formed. The anti-reflection film 22 reduces reflectance (or reflectivity) of the sun light that is incident to the front surface of the semiconductor substrate 10. Also, the anti-reflection film 22 passivates defects existing at a surface or a bulk of the emitter layer 20.

Since the reflectance of the sun light is reduced by the anti-reflection film 22, an amount of the sun light reaching the p-n junction formed between the semiconductor substrate 10 and the emitter layer 20 is increased, thereby increasing short circuit current (Isc) of the solar cell 100. Also, because the defects at the emitter layer 20 are passivated, recombination sites of minority carrier are reduced or eliminated, thereby increasing an open-circuit voltage (Voc) of the solar cell 100. Accordingly, the open-circuit voltage (Voc) and the short-circuit current (Isc) of the solar cell 100 are increased by the anti-reflection layer 22, and thus, the efficiency of the solar cell 100 can be enhanced.

The anti-reflection film 22 may include various materials. The anti-reflection film 22 may have a single film structure or a multi-layer film structure including, for example, at least one material selected from a group consisting of silicon nitride, silicon nitride including hydrogen, silicon oxide, silicon oxy nitride, MgF₂, ZnS, TiO₂ and CeO₂. However, embodiments of the invention are not limited thereto, and thus, the anti-reflection film 22 may include various materials.

The anti-reflection film 22 may be formed by various methods such as a vacuum evaporation method, a chemical vapor deposition method, a spin coating method, a screen printing method, or a spray coating method. Other methods may be used.

The first electrode 24 may include various metals having high electrical conductivity. For example, the first electrode 24 may include at least one bus electrode and/or at least one finger electrode having aluminum (Al) or silver (Ag) with high electrical conductivity. However, embodiments of the invention are not limited thereto. The first electrode 24 may be a single layer including transparent conductive materials, or may have a stacked structure having a transparent conductive layer and a metal layer (referred to as "a bus bar" or "a finger electrode") on the transparent conductive layer.

The first electrode 24 may be formed by various methods such as a screen printing method, a plating method, a deposition method, and so on.

The back surface field layer 30 is formed at the back surface of the semiconductor substrate 10, and has the first conductive type dopant with a doping concentration higher than that of the semiconductor substrate 10. The back surface field layer 30 can prevent recombination of electron-hole pairs at the back surface of the semiconductor substrate 10, and can enhance the efficiency of the solar cell 100. The back surface field layer 30 may include an n-type dopant such as phosphorus (P), arsenic (As), bismuth (Bi), antimony (Sb), or the like. However, embodiments of the invention are not limited thereto. Thus, when the semiconductor substrate 10 has a p-type dopant, the back surface field layer 30 may have a p-type dopant.

In the embodiment, the back surface field layer 30 includes a first portion 30a formed in between the second electrodes 34 where the second electrodes 34 are not formed, and a second portion 30b being in contact with the second electrode 34. The second portion 30b has a second resistance lower than a first resistance of the first portion 30a. That is, the back surface field layer 30 may have a selective back surface field structure in having the first portion 30a and the second portion 30b, and this will be described in detail later.

The back surface field layer 30 may be formed by various methods. For example, the back surface field layer 30 may be formed by an ion implantation method using a shadow mask, an etch-back method using a mask, a laser doping method, and so on.

The passivation film 32 and the second electrode 34 may be formed at the back surface of the semiconductor substrate 10.

The passivation film 32 may be substantially at the entire back surface of the semiconductor substrate 10, except for the portions where the second electrode 34 is formed. The passivation film 32 passivates defects at the back surface of the semiconductor substrate 10. Thus, an open circuit voltage (Voc) of the solar cell 100 can be increased.

The passivation film 32 may include a transparent insulating material for transmitting the light. Thus, the light can be incident to the back surface of the semiconductor substrate 10 through the passivation film 32, and thereby enhance the efficiency of the solar cell 100. The passivation film 32 may have a single film structure or a multi-layer film structure including, for example, at least one material selected from a group consisting of silicon nitride, silicon nitride including hydrogen, silicon oxide, silicon oxy nitride, MgF₂, ZnS, TiO₂ and CeO₂. However, embodiments of the invention are not limited thereto, and thus, the passivation film 32 may include various materials.

The passivation film 32 may be formed by various methods such as a vacuum evaporation method, a chemical vapor deposition method, a spin coating method, a screen printing method, or a spray coating method. Other methods may be used.

The second electrode 34 may include various metals having high electrical conductivity. For example, the second electrode 34 may include silver (Ag) having high electrical conductivity and high reflectance. When the second electrode 34 includes the silver having high reflectance, the second electrode 34 can reflect the light towards the back surface of the semiconductor substrate 10, and towards the inside of the semiconductor substrate 10. Thus, an amount of useable light can be increased.

The second electrode 34 may be formed by various methods such as a screen printing method, a plating method, a deposition method, and so on.

In this embodiment of the invention, the back surface field layer 30 having the selective back surface field structure and the second electrode 34 electrically connected to the back surface field layer 30 have structures for being able to maximize the efficiency of the solar cell 100. This will be described in more detail.

First, the back surface field layer 30 will be described. When the doping concentration of the back surface field layer 30 increases, the passivation property thereof may decrease. On the other hand, when the doping concentration of the back surface field layer 30 decreases, the passivation property thereof increases and a saturation current (Jo) at the passivation area decreases, although the saturation current at the electrode area increases and a series resistance (Rse) also increases. Thus, the product of the saturation current and the series resistance also increases. Accordingly, even though the doping concentration of the back surface field layer 30 decreases on the whole, the product of the saturation current and the series resistance increases, and thus, the efficiency of the solar cell 100 can not be maximized.

Thus, in the back surface field layer 30, the passivation area (involving the passivation) may have a relatively low doping concentration so that the passivation property can be improved, and the electrode area (being in contact with an electrode) may have a relatively high doping concentration so that the resistance can be reduced

In embodiments of the invention, the first portion 30a of the back surface field layer 30 is the passivation area for preventing the recombination of the electrons and the holes, and the second portion 30b of the back surface field layer 30 is the electrode area being in contact with the second electrode 34. Accordingly, the first portion 30a may have a relatively low doping concentration and a relatively high resistance, and the second portion 30b may have a relatively high doping concentration and a relatively low resistance.

Accordingly, the first portion 30a of the back surface field layer 30 has a resistance of about 70∼110 ohm/square, and the second portion 30b of the back surface field layer 30 has a resistance of about 20-40 ohm/square. When the first portion 30a has a resistance of about 70∼110 ohm/square, the passivation property can be maximized. Also, when the second portion 30b has a resistance of about 20-40 ohm/square, the resistance with the second electrode 34 can be reduced. However, embodiments of the invention are not limited thereto, and thus, the resistance may be varied.

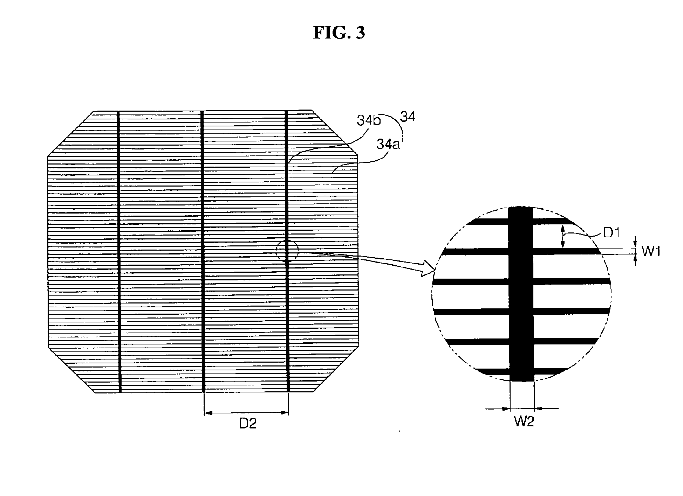

The second electrode 34 formed on the second portion 30b will be described in more detail with reference to FIG. 3. FIG. 3 is a plan view illustrating a second electrode of a solar cell according to an embodiment of the invention.

As shown in FIG. 3, the second electrode 34 may include a plurality of finger electrodes 34a. The finger electrodes 34a are parallel to each other and are spaced apart from each other with a first distance D1. Also, the second electrode 34 may include a bus electrode 34b being extended in a direction crossing the finger electrodes 34a to connect the finger electrodes 34a. The bus electrode 34b may include a single bus electrode 34b, or the bus electrode 34b includes a plurality of bus electrodes 34b as shown in FIG. 3. The plurality of bus electrodes 34b are spaced apart from each other with a second distance D2 that is larger than the first distance D1.

The bus electrode 34b and the finger electrodes 34a may be formed by the same process by using the same material (for example, silver). The bus electrode 34b and the finger electrodes 34a have thicknesses of about 15µm to about 30µm. When the thickness thereof is larger than about 30µm, the series resistance cannot be reduced, and the material used for manufacturing the electrodes 34a and 34b may increase and the productivity may decrease. When the thickness thereof is smaller than about 15µm, the series resistance may increase and the fill factor may increase also.

In this instance, the finger electrode 34a has a width W1 of about 50µm to about 70µm, and the finger electrodes 34a are spaced apart from each other with the first distance D1 of about 0.1mm to about 1mm. In addition, a width W2 of the bus electrode 34b is larger than the width W1 of the finger electrode 34a. For example, the bus electrode 34b may have the width of about 1 to about 2mm (more particularly, about 1 to about 1.5mm). The bus electrodes 34b are spaced apart from each other with the uniform second distance D2. The second distance D2 may be varied according to a number of the bus electrodes 34b. For example, two or three bus electrodes 34b are formed at one solar cell 100, and the second distance D1 may be about 20mm to about 40mm.

When the widths of the finger electrode 34a and/or the bus electrode 34b are larger than the above range, shading loss may increase, and thus, the efficiency of the solar cell 100 may decrease. Also, when the widths of the finger electrode 34a and/or the bus electrode 34b are smaller than the above range, the resistance may increase and it may be difficult to attach a ribbon to the second electrode 34 for modularization of the solar cell 100.

Also, when the first distance D1 between the finger electrodes 34a and/or the second distance D2 between the bus electrodes 34b is larger than the above range, it may be difficult to effectively collect the current generated by the solar cell 100. When the first distance D1 between the finger electrodes 34a and/or the second distance D2 between the bus electrodes 34b is smaller than the above range, the amount of the material used for manufacturing the second electrode 34 may increase.

Due to the first and second widths W1 and W2, and the first and second distances D1 and D2, an area ratio of the second electrode 34 with respect to the semiconductor substrate 10 may be about 7% to about 10%.

In a conventional solar cell, a back surface field layer has a uniform doping concentration, and an area ratio of a second electrode with respect to a semiconductor substrate is greater than about 12%. That is, in the conventional solar cell, the back surface field layer has a structure that increases the efficiency of the solar cell, and the amount of the material used for manufacturing a second electrode is large and the productivity is low because the area of the second electrode is large.

On the other hand, in this embodiment, the back surface field layer 30 includes the first portion 30a and the second portion 30b having different resistances, and thus, the passivation property and the efficiency of the solar cell 100 can be maximized. Also, in embodiments of the invention, when the solar cell 100 has the back surface field layer 30 of the selective back surface field structure, the second electrode 34 has the width and/or the distance suitable for minimizing the value of the product of the saturation current and the series resistance. Then, the passivation property of the back surface field layer 30 can be improved without an increase of the series resistance, and thus, the efficiency of the solar cell 100 can be maximized. In addition, since the width and the area ratio of the second electrode 34 decreases, the amount of the material used for manufacturing the second electrode 34 can decrease.

Hereinafter, embodiments of the invention will be described in greater detail through an experimental example. The experimental example is provided only for illustrative purpose of the embodiments of the invention and the embodiments of the invention are not limited thereto.

### Experimental Embodiment

A n-type semiconductor substrate was prepared. Boron as a p-type dopant was ion-implanted to a front surface of the semiconductor substrate to form an emitter layer, and phosphorus as an n-type dopant was ion-implanted to a back surface of the semiconductor substrate to form a back surface field layer. An anti-reflection film including silicon nitride was formed on the front surface of the semiconductor substrate, and the passivation film including silicon nitride layer and silicon oxide layer was formed on the back surface of the semiconductor substrate. Then, a first paste is screen-printed on the front surface of the semiconductor substrate, a second paste is screen-printed on the back surface of the semiconductor substrate, and they were fired to form a first electrode and a second electrode. And then, an isolation process was performed. In this instance, the back surface field layer included a first portion with a resistance of about 90 ohm/square and a second portion with a resistance of about 30 ohm/square.

Fifteen solar cells were manufactured. In the fifteen solar cells, finger electrodes of the second electrode had widths of about 60µm, about 70µm, about 80µm, about 90µm, or about 100µm, and a first distance between the finger electrodes were about 1mm, about 1.5mm, or about 2mm.

### Comparative Embodiment 1

Fifteen solar cells were manufactured by the same method as the Experimental Embodiment except that the back surface field layer had the uniform resistance of about 30 ohm/square.

### Comparative Embodiment 2

Fifteen solar cells were manufactured by the same method as the Experimental Embodiment except that the back surface field layer had the uniform resistance of about 60 ohm/square.

### Comparative Embodiment 3

Fifteen solar cells were manufactured by the same method as the Experimental Embodiment except that the back surface field layer had the uniform resistance of about 90 ohm/square.

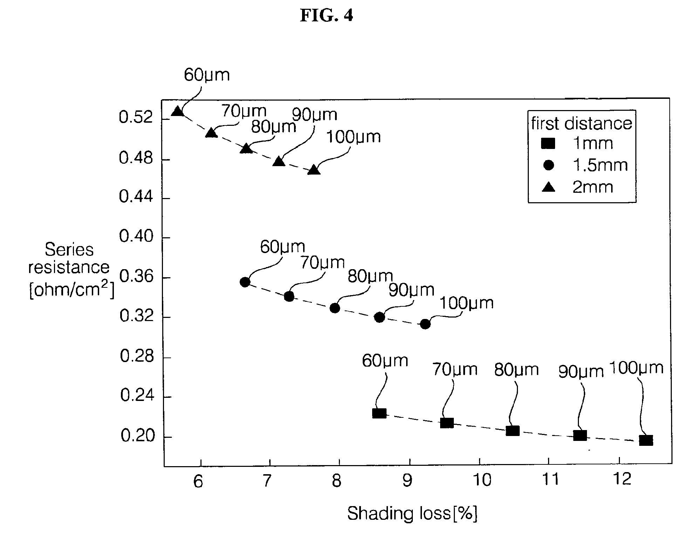

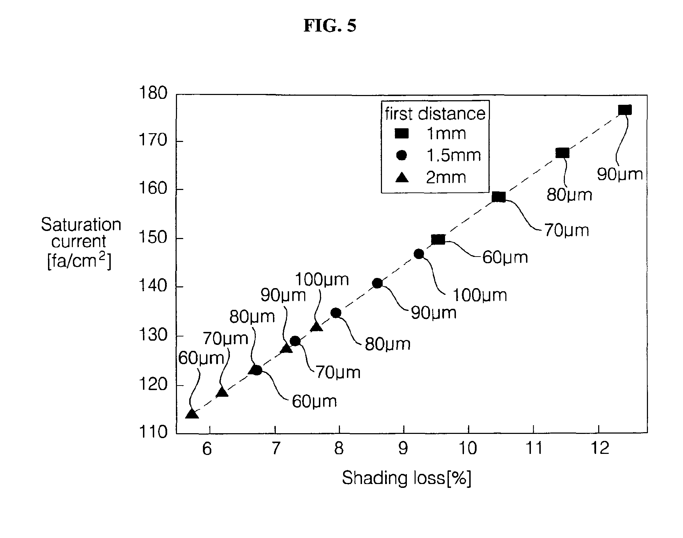

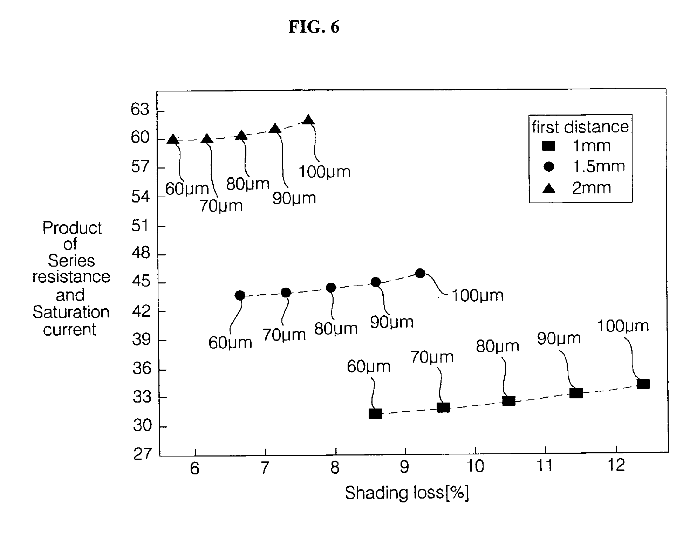

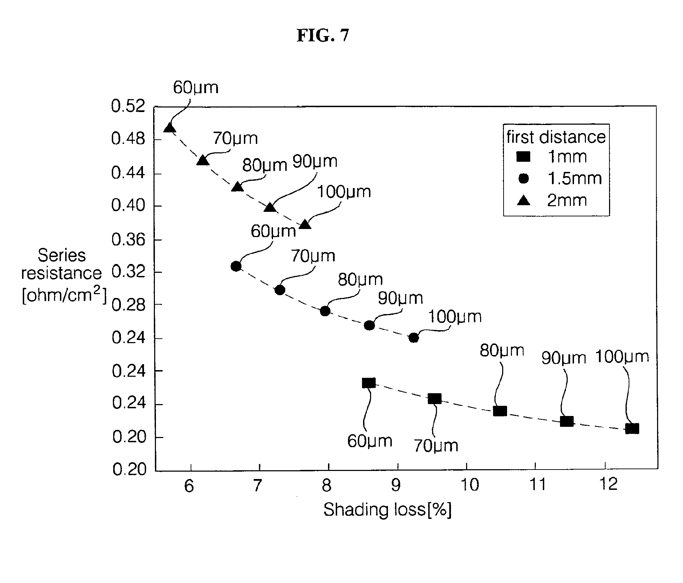

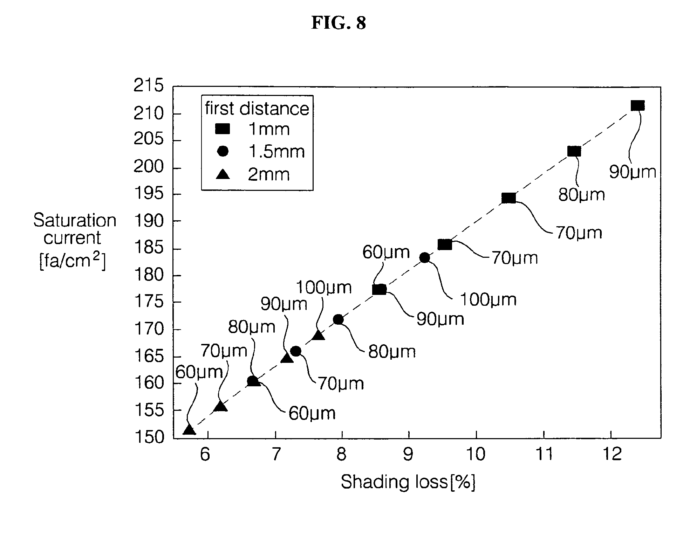

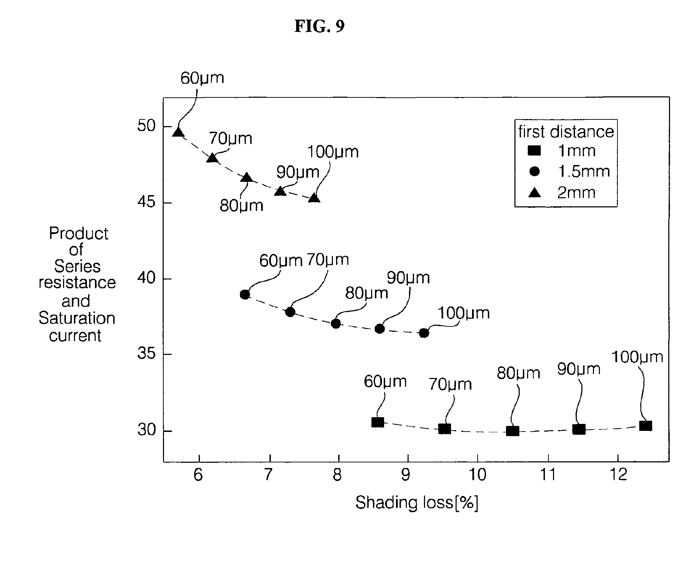

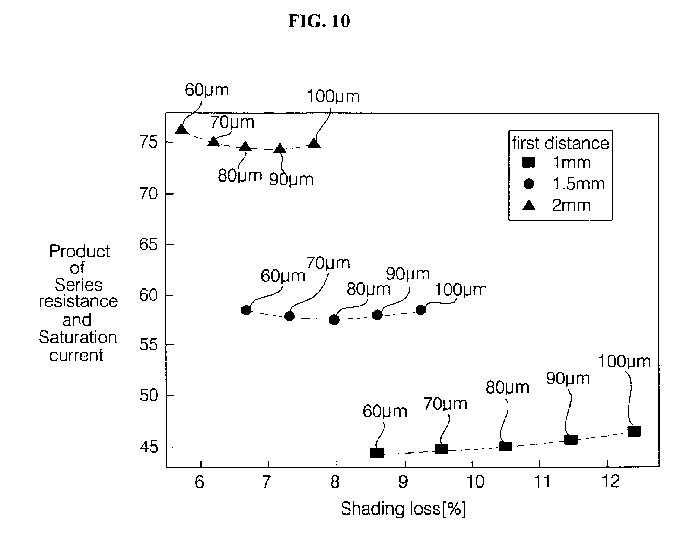

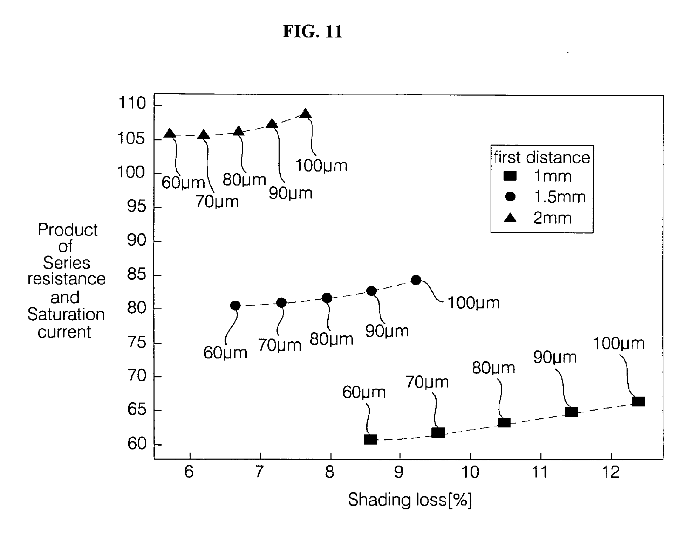

FIG. 4 is a graph of a series resistance of a solar cell of the Experimental Embodiment, and FIG. 5 is a graph of a saturation current of the solar cell of the Experimental Embodiment. FIG. 6 is a graph of a product of the series resistance and the saturation current of the solar cell of the Experimental Embodiment. FIG. 7 is a graph of a series resistance of a solar cell of the Comparative Embodiment 1, and FIG. 8 is a graph of a saturation current of the solar cell manufactured by Comparative Embodiment 1. FIG. 9 is a graph of a product of the series resistance and the saturation current of the solar cell manufactured by Comparative Embodiment 1, FIG. 10 is a graph of a product of the series resistance and the saturation current of the solar cell manufactured by Comparative Embodiment 2, and FIG. 11 is a graph of a product of the series resistance and the saturation current of the solar cell manufactured by Comparative Embodiment 3.

With reference to FIGS. 4 and 7, as the first distance decreases from about 2mm to about 1mm and the width of the finger electrode increases from about 60µm to about 100µm, the series resistance decreases. In this instance, it can be seen that the series resistance is influenced more by the first width than the width of the finger electrode.

With reference to FIGS. 5 and 8, as the first distance decreases from about 2mm to about 1mm and the width of the finger electrode increases from about 60µm to about 100µm, the saturation current increases.

With reference to FIG. 6, when the first distance of the finger electrode is about 1mm, the product of the saturation current and the series resistance is minimized, compared to the case when the first distance of the finger electrode is about 1.5mm or about 2mm. Also, when the width of the finger electrode is about 60µm or 70µm, the product of the saturation current and the series resistance is minimized, compared to the case when the width of the finger electrode is about 80µm, 90µm or 100µm. In this instance, when the first distance is smaller than about 0.5mm or the width is smaller than about 50µm, it is difficult to manufacture the first electrode with a desired dimension.

With reference to FIG. 9, when the first distance of the finger electrode is about 1mm, the product of the saturation current and the series resistance is minimized, compared to the case when the first distance of the finger electrode is about 1.5mm or about 2mm. Also, when the width of the finger electrode is about 80µm, the product of the saturation current and the series resistance is minimized.

When FIG. 6 and FIG. 9 are compared, in the Experimental Embodiment, when the product of the saturation current and the series resistance is minimized (that is, when the series resistance is about 30 when the width of the finger electrode is about 60µm or about 70µm and the first distance is about 1mm), the shading loss is low (about 8.5%). In the Comparative Embodiment 1, when the product of the saturation current and the series resistance is minimized (that is, when the series resistance is about 30 when the width of the finger electrode is about 80µm and the first distance is about 1mm), the shading loss is high (about 10.5%).

That is, in this embodiment, when the finger electrode has the width of about 50∼70µm and has the first distance of about 0.5∼1.5mm, the shading loss as well as the product of the saturation current and the series resistance can be minimized. Accordingly, the efficiency of the solar cell can be enhanced. In addition, the amount of the material used for manufacturing the second electrode can be reduced, and thus, the productivity can be enhanced.

With reference to FIGS. 10 and 11, the product of the saturation current and the series resistance of Comparative Embodiment 2 is larger than that of Comparative Embodiment 1, and the product of the saturation current and the series resistance of Comparative Embodiment 3 is larger than that of Comparative Embodiment 2. This is expected by the increase of the series resistance. When the resistance of the back surface field layer is about 30 ohm/square, the product of the saturation current and the series resistance is minimized. Considering this, in this embodiment, the first portion of the back surface field layer for passivation has the resistance of about 20-40 ohm/square, and thus, the product of the saturation current and the series resistance can be minimized. Also, the second portion of the back surface field being in contact with the second electrode may have the resistance of about 70∼110 ohm/square, and thus, the properties of the solar cell can be enhanced.

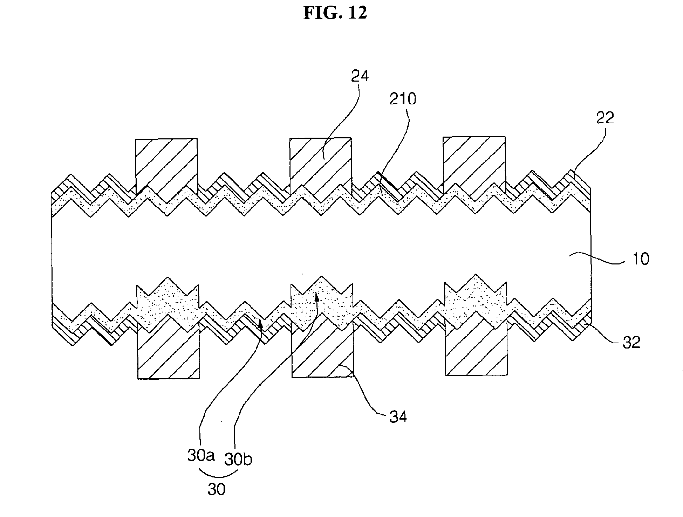

With reference to FIG. 2, in the above embodiment, the emitter layer 20 includes the first portion 20a and the second portion 20b having different resistances. However, embodiments of the invention are not limited thereto. Thus, as shown in FIG. 12, the emitter layer 210 may have a substantially uniform resistance on the whole. That is, the resistance of the portion where the first electrode 24 may be substantially the same as the resistance of the portion where the first electrode 24 is not formed.

According to embodiments of the invention, the back surface field layer 30 includes the first portion 30a and the second portion 30b having different resistance, and thus, the passivation property and the efficiency of the solar cell 100 can be maximized.

Also, when the solar cell 100 includes the back surface field layer 30 of the selective back surface field structure having the first portion 30a and the second portion 30b, the second electrode 34 can have the width and/or the distance suitable for minimizing the value of the product of the saturation current and the series resistance. Then, the passivation property can be improved without an increase of the series resistances, and thus, the efficiency of the solar cell 100 can be maximized. In addition, since the width and the area ratio of the second electrode 34 decreases, the amount of the material used for manufacturing the second electrode 34 can decrease.

Certain embodiments of the invention have been described. However, the invention is not limited to the specific embodiments described above; and various modifications of the embodiments are possible by those skilled in the art to which the invention belongs without leaving the scope defined by the appended claims.

## Claims

1. A solar cell, comprising:
a semiconductor substrate of a first conductive type;
an emitter layer of a second conductive type, and formed on at least one of a front surface and a back surface of the semiconductor substrate;
a back surface field layer formed on the back surface of the semiconductor substrate;
a first electrode formed on the emitter layer and electrically connected to the emitter layer; and
a second electrode formed on the back surface field layer and electrically connected to the back surface field layer,
wherein the back surface field layer comprises a first portion formed at a portion where the second electrode is not formed and having a first resistance, and a second portion in contact with the second electrode and having a second resistance lower than the first resistance,
the second electrode comprises a plurality of finger electrodes,
the plurality of finger electrodes are parallel to each other and are spaced apart from each other with distances of about 0.1mm to about 1mm, and
the plurality of finger electrodes have widths of about 50µm to about 70µm.

2. The solar cell according to claim 1, wherein the plurality of finger electrodes have thicknesses of about 15µm to about 30µm.

3. The solar cell according to claim 1, wherein the distances between the plurality of finger electrodes are substantially uniform.

4. The solar cell according to claim 1, further comprising a bus electrode extending in a direction crossing the plurality of finger electrodes and connected to the plurality of finger electrodes.

5. The solar cell according to claim 4, wherein a width of the bus electrode is larger than the widths of the plurality of finger electrodes.

6. The solar cell according to claim 4, wherein the bus electrode has a width of about 1mm to about 2mm.

7. The solar cell according to claim 6, wherein the bus electrode has a width of about 1mm to about 1.5mm.

8. The solar cell according to claim 4, wherein the bus electrode comprises a plurality of bus electrodes, and
wherein distances between the plurality of bus electrodes are substantially uniform.

9. The solar cell according to claim 8, wherein the number of the plurality of bus electrodes is less than the number of the plurality of finger electrodes.

10. The solar cell according to claim 4, wherein the bus electrode comprises a plurality of bus electrodes, and
wherein distances between the plurality of bus electrodes are larger than the distances between the plurality of the finger electrodes.

11. The solar cell according to claim 4, wherein the bus electrode comprises a plurality of bus electrodes, and
the plurality of bus electrodes are spaced apart from each other with distances of about 20mm to about 40mm.

12. The solar cell according to claim 4, wherein the bus electrode has a thickness of about 15µm to about 30µm.

13. The solar cell according to claim 1, wherein an area ratio of the second electrode with respect to the semiconductor substrate is about 7% to about 10%.

14. The solar cell according to claim 1, wherein the first resistance of the back surface field layer is about 70 ohm/square to about 110 ohm/square, and the second resistance of the back surface field layer is about 20 ohm/square to about 40 ohm/square.

15. The solar cell according to claim 4, wherein the bus electrode and the plurality of finger electrodes are in contact with the second portion of the back surface field layer.
